# EUROPEAN PATENT APPLICATION

(11) **EP 4 290 566 A1**
(43) Date of publication of application: **13.12.2023**
(21) Application number: 23175664.4
(22) Date of filing: 26.05.2023
(51) Int. Cl.: H01L 21/78

(54) **MANUFACTURING METHOD OF SEMICONDUCTOR DEVICE**

(30) Priority: 07.06.2022 JP 2022092482
(71) Applicant: Mitsuboshi Diamond Industrial Co., Ltd., Settsu, Osaka 566-0034 (JP)
(72) Inventor: UECHA, Masashi, Nisshin-shi, 470-0111 (JP); NAGUMO, Yuji, Nisshin-shi, 470-0111 (JP); OKUDA, Masaru, Nisshin-shi, 470-0111 (JP); NAGAYA, Masatake, Nisshin-shi, 470-0111 (JP); KITAICHI, Mitsuru, Settsu-city, 566-0034 (JP); MORI, Akira, Settsu-city, 566-0034 (JP); KIYAMA, Naoya, Settsu-city, 566-0034 (JP); TAKEDA, Masakazu, Settsu-city, 566-0034 (JP)
(74) Representative: TBK

(57) **Abstract**

A manufacturing method of a semiconductor device includes preparing a semiconductor substrate (2) having a plurality of element regions (3) and having a first surface (2a) and a second surface (2b) opposite to each other, forming a crack (5) extending in a thickness direction of the semiconductor substrate along a boundary between the plurality of element regions by pressing a pressing member (32) against the first surface of the semiconductor substrate (2) along the boundary, forming a metal film (8) over the plurality of element regions on the first surface of the semiconductor substrate after the forming of the crack, and dividing the semiconductor substrate and the metal film along the boundary by pressing a dividing member (33) against the semiconductor substrate along the boundary from a direction facing the second surface of the semiconductor substrate after the forming of the metal film.

## Description

The present disclosure relates to a manufacturing method of a semiconductor device.

JP 2017-41525 A discloses a manufacturing method of a semiconductor device in which a semiconductor substrate has a metal film formed on a rear surface thereof. In the manufacturing method, dividing grooves are formed along planned dividing lines by plasma etching on a front surface of the semiconductor substrate that has the metal film formed on the rear surface. The dividing grooves are formed so as to leave remaining portions having a predetermined thickness between the dividing grooves and the metal film, and the dividing grooves do not reach the metal film from the front surface of the semiconductor substrate. Thereafter, an external force is applied from the front surface of the semiconductor substrate along the planned dividing lines to divide the remaining portions left between the dividing grooves and the metal film. The metal film is divided by the impact when the remaining portions are divided.

In the manufacturing method described in JP 2017-41525 A, since the dividing grooves are formed so as to leave the remaining portions having the predetermined thickness, it is necessary to accurately control the depth of the dividing grooves. In addition, since plasma etching or the like is used when the dividing grooves are formed, the manufacturing cost is high. The present disclosure proposes a new technique for dividing a semiconductor substrate that has a metal film formed on a surface thereof.

A manufacturing method of a semiconductor device according to one aspect of the present disclosure includes preparing a semiconductor substrate having a plurality of element regions and having a first surface and a second surface opposite to each other, forming a crack extending in a thickness direction of the semiconductor substrate along a boundary between the plurality of element regions by pressing a pressing member against the first surface of the semiconductor substrate along the boundary, forming a metal film over the plurality of element regions on the first surface of the semiconductor substrate after the forming of the crack, and dividing the semiconductor substrate and the metal film along the boundary by pressing a dividing member against the semiconductor substrate along the boundary from a direction facing the second surface of the semiconductor substrate after the forming of the metal film.

In the manufacturing method according to the one aspect of the present disclosure, first, the pressing member is pressed against the first surface of the semiconductor substrate to form the crack in the semiconductor substrate. The crack is formed from a direction facing the first surface. Thereafter, the metal film is formed on the first surface, and the dividing member is pressed from the direction facing the second surface. Since the crack is formed on the first surface of the semiconductor substrate, a distance from a tip portion of the dividing member is long. Therefore, when the dividing member is pressed against the semiconductor substrate from the direction facing second surface, a force is applied in a direction in which the crack is spread and regions adjacent to each other across the crack are separated from each other. As a result, the crack extends in the thickness direction of the semiconductor substrate. Accordingly, the semiconductor substrate is divided along the boundary of the element regions. In addition, similarly to the regions of the semiconductor substrate adjacent to each other across the crack, a force is also applied to regions of the metal film adjacent to each other across the crack in a separating direction, and the regions of the metal film adjacent to each other across the crack are also separated from each other to divide the metal film. As described above, in the manufacturing method according to the one aspect of the present disclosure, the metal film can be divided together with the semiconductor substrate by simple processes of pressing the pressing member and the dividing member against the semiconductor substrate. In addition, since the crack is formed in advance on the first surface of the semiconductor substrate before the metal film is formed on the first surface, both the semiconductor substrate and the metal film can be divided in one step of pressing the dividing member from the direction facing the second surface.

Additional objects and advantages of the present disclosure will be more readily apparent from the following detailed description when taken together with the accompanying drawings. In the drawings:
FIG. 1 is a plan view of a semiconductor substrate;
FIG. 2 is a diagram for explaining a support plate attaching process;
FIG. 3 is a diagram for explaining a grinding process;
FIG. 4 is a diagram for explaining a crack forming process;
FIG. 5 is a diagram for explaining a state in which a crack is formed;
FIG. 6A is a scanning electron microscope image of a cross section of a semiconductor substrate with a crack as viewed obliquely from above;
FIG. 6B is a scanning electron microscope image of the cross section of the semiconductor substrate with the crack;
FIG. 7 is a diagram for explaining a metal film forming process;
FIG. 8 is a diagram for explaining a dicing tape attaching process;
FIG. 9 is diagram for explaining a support plate detaching process;
FIG. 10 is a diagram for explaining a protective member covering process;
FIG. 11 is a diagram for explaining a dividing process; and
FIG. 12 is a diagram for explaining a pickup process.

According to another aspect of the present disclosure, the manufacturing method may further include attaching a support substrate to the second surface of the semiconductor substrate before the forming of the crack, and detaching the support substrate from the second surface of the semiconductor substrate after the forming of the metal film and before the dividing of the semiconductor substrate and the metal film.

In the manufacturing method described above, the crack is formed in the semiconductor substrate in a state where the support plate is attached to the semiconductor substrate. When the support plate is made of a hard material, the crack can be formed in the semiconductor substrate with a relatively low load when the pressing member is pressed against the semiconductor substrate.

According to another aspect of the present disclosure, the pressing member may be a scribing wheel, the pressing of the pressing member may include rolling of the scribing wheel, and the forming of the crack may include forming, on the first surface, a scribe line with the crack extending in the thickness direction of the semiconductor substrate along the boundary.

In the manufacturing method described above, the scribing wheel having a circular plate shape is rotatably and pivotally supported and is rolled, so that the crack can be easily formed along the boundary of the element regions.

According to another aspect of the present disclosure, the manufacturing method may further include attaching a dicing tape to a surface of the metal film after the forming of the metal film and before the detaching of the support plate from the second surface.

In the manufacturing method described above, the semiconductor substrate and the metal film are divided in a state where the dicing tape is attached. Since the semiconductor substrate and the metal film are fixed to the dicing tape, it is possible to restrict displacement of the semiconductor substrate when the dividing member is pressed against the semiconductor substrate, and it is possible to restrict scattering of the obtained semiconductor devices, that is, divided semiconductor substrates.

According to another aspect of the present disclosure, the manufacturing method may further include covering the second surface with a protective member before the dividing of the semiconductor substrate and the metal film. The dividing of the semiconductor substrate and the metal film may include pressing the dividing member along the boundary from the direction facing the second surface via the protective member.

In the manufacturing method described above, the dividing member is pressed against the semiconductor substrate in a state where the second surface is covered with the protective member. Since the second surface is protected by the protective member, it is possible to restrict the second surface from being damaged by the dividing member.

### (Embodiment)

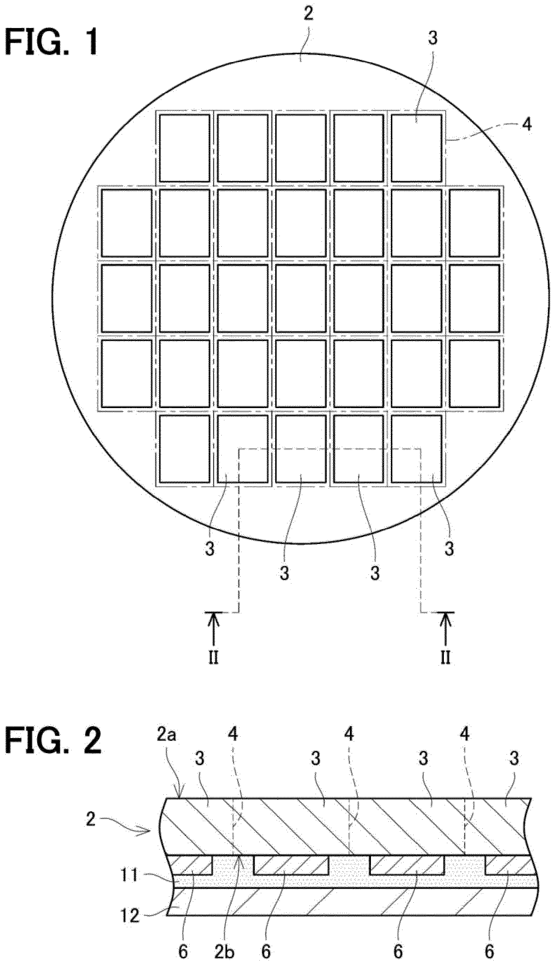

A manufacturing method of a semiconductor device according to an embodiment of the present disclosure will be described with reference to the drawings. FIG. 1 is a plan view of a semiconductor substrate 2 in which multiple element regions 3 are formed in a matrix. In FIG. 1, each of the element regions 3 is schematically illustrated by a solid line. For convenience of description, lines that are boundaries between adjacent element regions 3 and serves as edge sides of individual element regions (semiconductor devices) after the semiconductor substrate 2 is divided into individual element regions 3 are referred to as planned dividing lines 4. The planned dividing lines 4 are not actually drawn on the semiconductor substrate 2, but are virtual lines. The planned dividing lines 4 may be lines or grooves actually drawn on the semiconductor substrate 2 so as to be visible. In each of the element regions 3, a semiconductor element having a function such as a transistor or a diode is formed.

The semiconductor substrate 2 is made of silicon carbide (SiC). The semiconductor substrate 2 may be made of another semiconductor material such as silicon (Si) or gallium nitride (GaN). As shown in FIG. 2 and the like, the semiconductor substrate 2 has a first surface 2a and a second surface 2b located opposite to each other. On the second surface 2b of the semiconductor substrate 2, a main structure 6 of the semiconductor element such as a gate and a channel is formed.

The manufacturing method of the present embodiment includes a support plate attaching process, a crack forming process, a metal film forming process, a dicing tape attaching process, a support plate detaching process, a protective member covering process, and a dividing process.

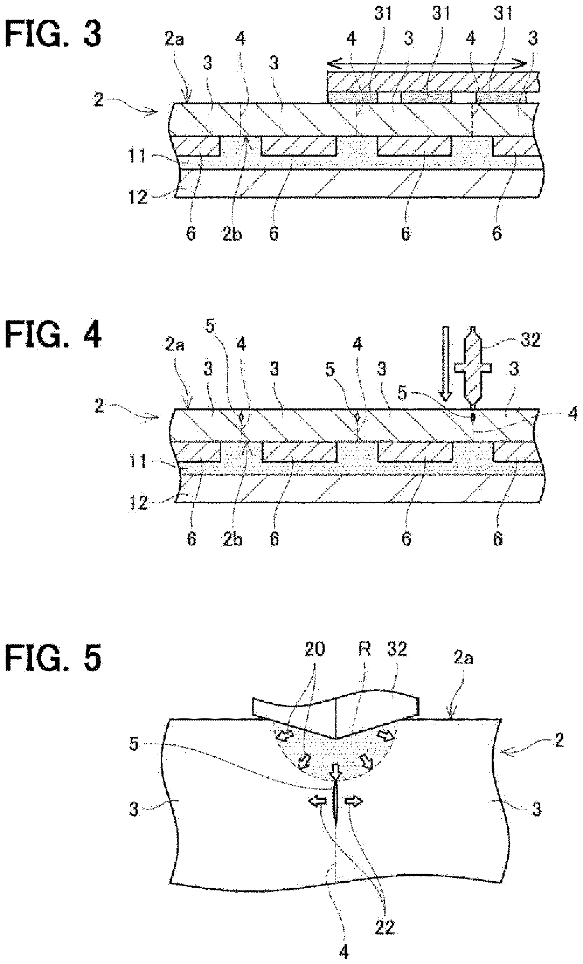

In the support plate attaching process, as shown in FIG. 2, a support plate 12 is attached to the second surface 2b of the semiconductor substrate 2. The support plate 12 is attached to the second surface 2b via an adhesive 11. The support plate 12 is made of, for example, glass. The adhesive 11 is, for example, a silicon-based adhesive. The adhesive 11 has a function of protecting the main structure 6 formed on the second surface 2b of the semiconductor substrate 2 in addition to a function of bonding the semiconductor substrate 2 to the support plate 12. Therefore, the adhesive 11 is applied such that a thickness of the adhesive 11 is greater than a thickness of the main structure 6. Thereafter, as shown in FIG. 3, the first surface 2a of the semiconductor substrate 2 is ground by a grinding wheel 31 as necessary. As a result, the semiconductor substrate 2 is thinned.

Next, the crack forming process shown in FIG. 4 is performed. In the crack forming process, a scribing wheel 32 is pressed against the first surface 2a of the semiconductor substrate 2 attached to the support plate 12 to form a scribe line with a crack 5 in the semiconductor substrate 2. The scribing wheel 32 is a disk-shaped (that is, circular shaped) member and is rotatably supported by a support apparatus (not shown). The scribing wheel 32 is moved (scanned) along the planned dividing lines 4 while being pressed against the first surface 2a of the semiconductor substrate 2. When moving along the planned dividing lines 4, the scribing wheel 32 rolls on the first surface 2a of the semiconductor substrate 2 like a tire rolling on a road surface. The scribing wheel 32 has a sharp peripheral edge portion, and forms lines (scribe lines) in which the semiconductor substrate 2 is plastically deformed along the planned dividing lines 4 on the first surface 2a of the semiconductor substrate 2. In the present embodiment, the scribing wheel 32 is pressed against the first surface 2a with a load of about 2.0 N.

As shown in FIG. 5, when the first surface 2a is pressed by the scribing wheel 32, a compressive stress is generated in a region R of a surface layer of the first surface 2a inside the semiconductor substrate 2. As indicated by arrows 20, the compressive stress is isotropically generated from a portion pressed by the scribing wheel 32, that is, a contact portion between the peripheral portion of the scribing wheel 32 and the first surface 2a. While the scribe line is formed at the portion pressed by the scribing wheel 32, tensile stress is generated in the semiconductor substrate 2 directly below a region where the compressive stress is generated. As indicated by arrows 22, the tensile stress is generated along the first surface 2a of the semiconductor substrate 2 in a direction away from the planned dividing line 4 directly below the region where the compressive stress is generated. Due to the tensile stress, the crack 5 extending in a thickness direction of the semiconductor substrate 2 is formed inside the semiconductor substrate 2. In the present embodiment, by moving the scribing wheel 32 along the planned dividing line 4 while pressing the scribing wheel 32 against the first surface 2a, the crack 5 is formed along the boundary between the adjacent element regions 3 so as to extend in the thickness direction of the semiconductor substrate 2. The crack 5 is formed in the vicinity of the surface layer of the first surface 2a of the semiconductor substrate 2. In general, compressive stress restricts formation and extension of cracks. Thus, the crack 5 is formed so as to extend from an outside of the region of the first surface 2a of the semiconductor substrate 2 where the compressive stress is generated by the scribing wheel 32 to the region where the tensile stress is generated directly below the region where the compressive stress is generated. The scribing wheel 32 is an example of a pressing member.

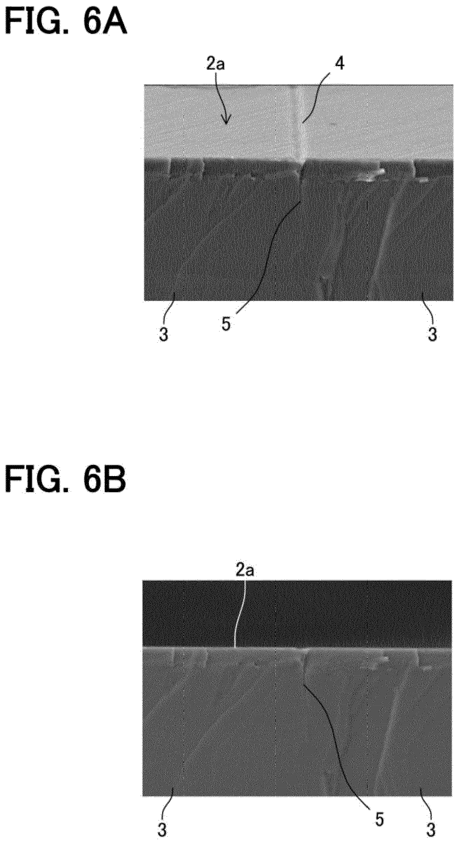

FIGS. 6A and 6B are scanning electron microscope images of a cross section of the semiconductor substrate 2 after the forming of the crack 5 by the scribing wheel 32. FIG. 6A is a view of the cross section of the vicinity of the first surface 2a of the semiconductor substrate 2 as viewed obliquely from above, and FIG. 6B is a view of the cross section of the vicinity of the first surface 2a of the semiconductor substrate 2. As shown in FIGS. 6A and 6B, by pressing the scribing wheel 32 along the planned dividing line 4, the crack 5 is formed at a portion of the semiconductor substrate 2 adjacent to the first surface 2a along the boundary of the element regions 3. Further, as shown in FIG. 6A, the scribe line is observed to be slightly recessed on the first surface 2a of the semiconductor substrate 2 due to the plastic deformation of the semiconductor substrate 2 by the scribing wheel 32. In FIGS. 6A and 6B, the depth of the crack 5 in the thickness direction of the semiconductor substrate 2 is about 6 µm.

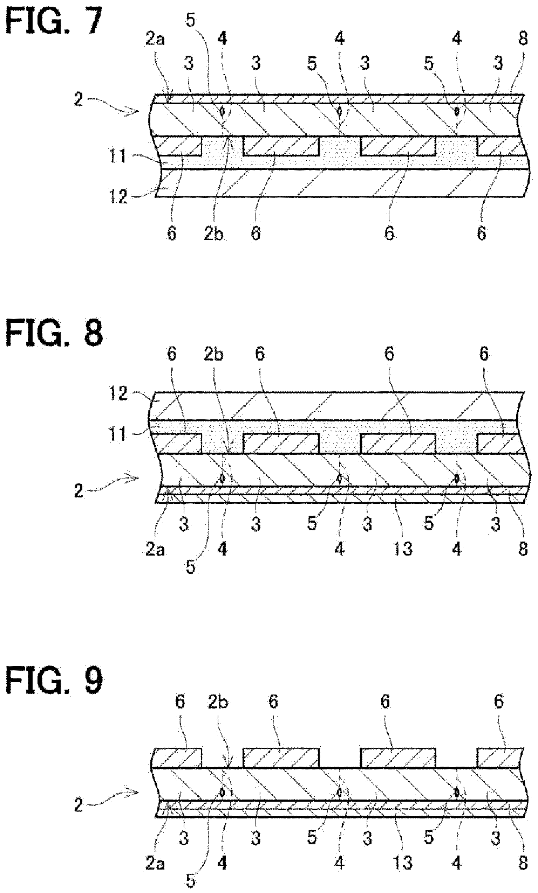

Next, the metal film forming process shown in FIG. 7 is performed. In the metal film forming process, the metal film 8 is formed on the first surface 2a of the semiconductor substrate 2. The material constituting the metal film 8 is not particularly limited, and may be, for example, a multilayer film in which titanium, nickel, and gold are stacked. The metal film 8 is formed so as to cover substantially the entire region of the first surface 2a. That is, the metal film 8 is formed on the first surface 2a so as to extend over the element regions 3. The metal film 8 functions as an electrode of the completed semiconductor device.

Next, the dicing tape attaching process shown in FIG. 8 is performed. In the dicing tape attaching process, a dicing tape 13 is attached to a surface of the metal film 8. The dicing tape 13 is attached so as to cover substantially the entire region of the metal film 8. The dicing tape 13 is fixed to a dicing frame (not shown). It should be noted that the semiconductor substrate 2 is illustrated with the second surface 2b facing up in FIG. 8 and subsequent drawings.

Next, the support plate detaching process shown in FIG. 9 is performed. In the support plate detaching process, the support plate 12 and the adhesive 11 are peeled off from the second surface 2b of the semiconductor substrate 2. For example, by dissolving the adhesive 11 with a solvent, the support plate 12 is peeled from the second surface 2b together with the adhesive 11. Accordingly, the semiconductor substrate 2 is supported by the dicing tape 13.

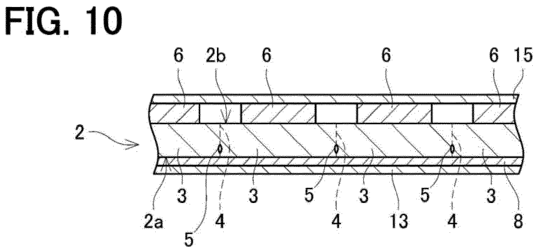

Next, the protective member covering process shown in FIG. 10 is performed. In the protective member coating process, the second surface 2b of the semiconductor substrate 2 is covered with a protective member 15 by attaching the protective member 15 so as to extend over the surfaces of the main structures 6 of the element regions 3 of the semiconductor substrate 2. The material of the protective member 15 is not particularly limited, and may be, for example, a resin or the like. By covering with protective member 15, the second surface 2b of the semiconductor substrate 2 is protected in the dividing process or the like performed later.

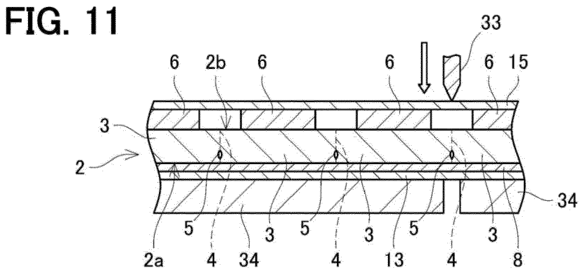

Next, the dividing process shown in FIG. 11 is performed. In the dividing process, a breaking plate 33 is pressed along the planned dividing line 4 (that is, the crack 5 formed in the crack forming process), and the semiconductor substrate 2 is divided along the planned dividing line 4 (that is, along the boundary of the element regions 3). First, the semiconductor substrate 2 is placed on two support bases 34. The two support bases 34 are spaced apart from each other so as to have a gap therebetween. When the semiconductor substrate 2 is placed on the support bases 34, the semiconductor substrate 2 is placed so that the gap is located below the position where the semiconductor substrate 2 is to be divided (that is, the position where the breaking plate 33 is to be pressed). Thereafter, the breaking plate 33 is pressed against the second surface 2b of the semiconductor substrate 2 via the protective member 15. The breaking plate 33 is a plate-like member. A lower end of the breaking plate 33 (that is, an end edge pressed against the second surface 2b) has a ridgeline shape (that is, a sharp edge shape), but is only pressed against the semiconductor substrate 2 without cutting the semiconductor substrate 2.

Since the support bases 34 are not present below the breaking plate 33 but the gap between the two support bases 34 is located, when the breaking plate 33 is pressed against the second surface 2b, the semiconductor substrate 2 is bent so as to enter the gap between the two support bases 34. The crack 5 has been formed at the portion of the semiconductor substrate 2 adjacent to the first surface 2a. Therefore, when the breaking plate 33 is pressed against the semiconductor substrate 2 from the direction facing the second surface 2b, the semiconductor substrate 2 is bent about the pressed portion (line), and, in a portion close to the first surface 2a, a force is applied to the crack 5 in a direction in which the crack 5 is spread and the two element regions 3 adjacent to the crack 5 are separated. As described above, the tensile stress is applied to the periphery of the crack 5. Therefore, when the breaking plate 33 is pressed against the second surface 2b, the crack 5 extends in the thickness direction of the semiconductor substrate 2, and the semiconductor substrate 2 is divided along the planned dividing line 4. In addition, since the metal film 8 is formed on the first surface 2a of the semiconductor substrate 2, a force is also applied to the metal film 8 in a direction in which the two element regions 3 adjacent to the dividing position are separated, and the metal film 8 is deformed and divided so as to be separated. Instead of the two support bases 34, the entire region of the first surface 2a of the semiconductor substrate 2 may be supported by one elastic support plate or one or more support bases via one elastic support plate. In this case, although the elastic support plate is present below the breaking plate 33, when the semiconductor substrate 2 is bent, the elastic support plate is deformed according to the bending of the semiconductor substrate 2. Therefore, when the breaking plate 33 is pressed against the second surface 2b, a force is applied to the crack 5 in a direction in which the two element regions 3 adjacent to the dividing position are separated from each other, as in the case where the semiconductor substrate 2 is supported by the two support bases 34 (that is, the case where the support base 34 is not present below the breaking plate 33). The breaking plate 33 is an example of a "dividing member".

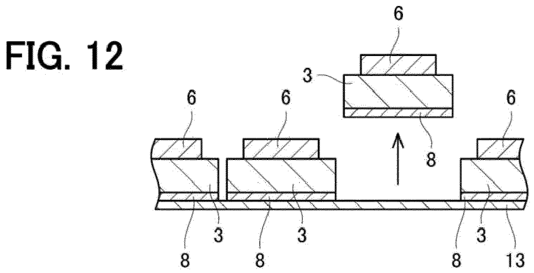

In the dividing process, the process of pressing the breaking plate 33 against the second surface 2b is repeatedly performed along each planned dividing line 4. Accordingly, the semiconductor substrate 2 and the metal film 8 can be divided along the boundaries between the element regions 3. Thereafter, as shown in FIG. 12, the divided element regions 3 with the metal film 8 are separated from the dicing tape 13. When the divided element regions 3 with the metal film 8 are separated from the dicing tape 13, the dicing tape 13 is expanded, and the divided element regions 3 with the metal film 8 can be separated from each other. Accordingly, the semiconductor devices with the metal film 8 (electrode) formed on the surface are completed.

As described above, in the present embodiment, first, the scribing wheel 32 is pressed against the first surface 2a of the semiconductor substrate 2 to form the crack 5 at the portion of the semiconductor substrate 2 adjacent to the first surface 2a. Since the crack 5 is formed at the portion of the semiconductor substrate 2 adjacent to the first surface 2a, when the breaking plate 33 is pressed from the direction facing the second surface 2b, the semiconductor substrate 2 is bent along the crack 5. Thus, a force is applied in a direction in which the semiconductor substrate 2 is bent and spread along the crack 5 from the direction facing the first surface 2a. As a result, the crack 5 extends in the thickness direction of the semiconductor substrate 2, and the semiconductor substrate 2 can be easily divided along the boundary of the element regions 3. Further, since the metal film 8 is formed on the first surface 2a of the semiconductor substrate 2, a force is also applied to the metal film 8 in the direction of separating the metal film 8 on both sides of the crack 5, the metal film 8 is deformed, and the metal film 8 can be easily divided. As described above, in the present embodiment, the metal film 8 can be divided together with the semiconductor substrate 2 by a simple process of pressing the scribing wheel 32 and the breaking plate 33 against the semiconductor substrate 2.

Further, in the present embodiment, since the crack 5 is formed in advance at the portion inside the semiconductor substrate 2 adjacent to the first surface 2a before the metal film 8 is formed on the first surface 2a, the semiconductor substrate 2 and the metal film 8 can be divided together in one step of pressing the breaking plate 33 from the direction facing the second surface 2b. In the present embodiment, the crack 5 is formed at the portion of the semiconductor substrate 2 adjacent to the first surface 2a before the metal film 8 is formed on the first surface 2a. Therefore, as compared with the case where the scribing wheel 32 is pressed against the first surface 2a via the metal film 8 to form the crack 5, the crack 5 can be formed with a low load, so that damage to the semiconductor substrate 2 can be reduced. In addition, as compared with a case where a scribing wheel is pressed against the second surface 2b of the semiconductor substrate 2 to form a crack, damage to a boundary between element regions on the second surface 2b (that is, a peripheral portion of the obtained semiconductor device) can be reduced.

In the present embodiment, the crack 5 is formed at the portion of the semiconductor substrate 2 adjacent to the first surface 2a in a state where the support plate 12 made of glass is attached to the semiconductor substrate 2. Since the support plate 12 is made of a relatively hard material, the crack 5 can be formed at the portion of the semiconductor substrate 2 adjacent to the first surface 2a with a relatively low load when the scribing wheel 32 is pressed against the semiconductor substrate 2.

In addition, in the present embodiment, the semiconductor substrate 2 and the metal film 8 are divided in a state where the dicing tape 13 is attached. Since the semiconductor substrate 2 and the metal film 8 are fixed to the dicing tape 13, when the breaking plate 33 is pressed against the semiconductor substrate 2, it is possible to restrict the displacement of the semiconductor substrate 2 and to restrict scattering of the obtained semiconductor devices.

In the present embodiment, the breaking plate 33 is pressed against the semiconductor substrate 2 in a state where the second surface 2b is covered with the protective member 15. Since the second surface 2b is protected by the protective member 15, it is possible to restrict the second surface 2b from being damaged by the breaking plate 33.

In the embodiment described above, the support plate attaching process, the dicing tape attaching process, and the protective member covering process may be omitted.

Although the embodiments have been described in detail above, these are merely examples and do not limit the scope of claims. The techniques described in the claims include various modifications and modifications of the specific examples illustrated above. The technical elements described in the present specification or the drawings exhibit technical usefulness alone or in various combinations, and are not limited to the combinations described in the claims at the time of filing. In addition, the techniques illustrated in the present specification or drawings achieve a plurality of objectives at the same time, and achieving one of the objectives itself has technical usefulness.

A manufacturing method of a semiconductor device includes preparing a semiconductor substrate (2) having a plurality of element regions (3) and having a first surface (2a) and a second surface (2b) opposite to each other, forming a crack (5) extending in a thickness direction of the semiconductor substrate along a boundary between the plurality of element regions by pressing a pressing member (32) against the first surface of the semiconductor substrate (2) along the boundary, forming a metal film (8) over the plurality of element regions on the first surface of the semiconductor substrate after the forming of the crack, and dividing the semiconductor substrate and the metal film along the boundary by pressing a dividing member (33) against the semiconductor substrate along the boundary from a direction facing the second surface of the semiconductor substrate after the forming of the metal film.

## Claims

1. A manufacturing method of a semiconductor device, comprising:
preparing a semiconductor substrate (2) having a plurality of element regions (3) and having a first surface (2a) and a second surface (2b) opposite to each other;
forming a crack (5) extending in a thickness direction of the semiconductor substrate along a boundary between the plurality of element regions by pressing a pressing member (32) against the first surface of the semiconductor substrate (2) along the boundary;
forming a metal film (8) over the plurality of element regions on the first surface of the semiconductor substrate after the forming of the crack; and
dividing the semiconductor substrate and the metal film along the boundary by pressing a dividing member (33) against the semiconductor substrate along the boundary from a direction facing the second surface of the semiconductor substrate after the forming of the metal film.

2. The manufacturing method according to claim 1, wherein
the pressing member is a scribing wheel,
the pressing of the pressing member includes rolling of the scribing wheel, and
the forming of the crack includes forming, on the first surface, a scribe line with the crack extending in the thickness direction of the semiconductor substrate along the boundary.

3. The manufacturing method according to claim 1, further comprising:
attaching a support plate (12) to the second surface before the forming of the crack; and
detaching the support plate from the second surface after the forming of the metal film and before the dividing of the semiconductor substrate and the metal film.

4. The manufacturing method according to claim 3, further comprising
attaching a dicing tape (13) to a surface of the metal film after the forming of the metal film and before the detaching of the support plate.

5. The manufacturing method according to any one of claims 1 to 4, further comprising
covering the second surface with a protective member (15) before the dividing of the semiconductor substrate and the metal film, wherein
the dividing of the semiconductor substrate and the metal film includes pressing the dividing member against the semiconductor substrate along the boundary from the direction facing the second surface via the protective member.
